# EUROPEAN PATENT APPLICATION

(11) **EP 4 246 593 A1**
(43) Date of publication of application: **20.09.2023**
(21) Application number: 21892300.1
(22) Date of filing: 09.11.2021
(51) Int. Cl.: H01L 29/45, H01L 29/778, H01L 29/66, H01L 29/20

(54) **METHOD FOR FORMING OHMIC CONTACT OF GAN-BASED ELECTRONIC DEVICE, AND OHMIC CONTACT OF GAN-BASED ELECTRONIC DEVICE,MANUFACTURED THEREBY**

(30) Priority: 13.11.2020 KR 20200152272
(71) Applicant: Korea Atomic Energy Research Institute, Daejeon 34057 (KR)
(72) Inventor: KIM, Dong Seok, Daegu 41203 (KR); YOON, Young Jun, Daegu 41574 (KR); LEE, Jae Sang, Daegu 42178 (KR)
(74) Representative: Regimbeau
(86) International application number: PCT/KR2021/016283
(87) International publication number: WO 2022/103133

(57) **Abstract**

The present invention relates to: a method for forming an ohmic contact of a GaN-based electronic device, comprising the steps of (A) irradiating an ion beam at a GaN-based electronic device to form an ion region in one part of the inside of the GaN-based electronic device, (B) forming an electrode layer on a part, corresponding to the ion region, of the surface of the GaN-based electronic device, and (C) thermally treating the GaN-based electronic device on which the electrode layer is formed; and an ohmic contact of a GaN-based electronic device manufactured by the method for forming an ohmic contact of a GaN-based electronic device.

## Description

### [Technical Field]

The present invention relates to a method for forming ohmic contact of a GaN-based electronic device and an ohmic contact of the GaN-based electronic device manufactured by the method.

### [Background Art]

A gallium nitride(GaN)-based electronic devices may form a two-dimensional electron gas(2DEG) with high electron concentration and fast electron mobility, so the device may be used as a high-frequency electronic device.

In order to secure excellent high-frequency characteristics of the gallium nitride-based electronic device as described above, it is important to reduce the on-resistance of the device. While the gallium nitride-based electronic device can have low channel resistance using 2DEG, it is difficult to obtain an ohmic contact with a low resistance value in source and drain regions due to a wide bandgap of gallium nitride.

In order to solve this problem, conventionally, titanium(Ti) is deposited and a high-temperature annealing process of 800 °C or more is performed. In this annealing process, the deposited titanium and nitrogen derived from gallium nitride react with each other to form titanium nitride(TiN), thereby forming an ohmic contact. However, since the conventional ohmic contact formation process requires the annealing process at a fairly high temperature, the process should be performed after deposing a surface passivation layer additionally by damaging the surface of the device.

In addition, a gate is formed after the source/drain is formed due to a high-temperature annealing process for forming the source/drain region, which imposes restrictions on changing the device manufacturing process to be performed to improve the performance of the device. Above all, since there is a limit to lowering the ohmic contact resistance only by the high-temperature annealing process, efforts are continuously being made to improve the process terms of simplification, stability, and performance of the process.

### [DISCLOSURE]

### [Technical Problem]

The present invention is to solve the above problems, and provides a method for forming an ohmic contact capable of overcoming the limit of ohmic contact resistance, which is difficult to be lowered by a thermal treatment process alone, and obtaining a resistance value required in a high-frequency electronic device despite forming an ohmic contact at a low thermal treatment temperature, and an ohmic contact manufactured by the method.

### [Technical Solution]

One embodiment of the present invention provides a method for forming an ohmic contact of a GaN-based electronic device, comprising (A) irradiating an ion beam on a GaN-based electronic device to form an ion region in a part of an inside of the GaN-based electronic device; (B) forming an electrode layer on a portion of a surface of the GaN-based electronic device, corresponding to the ion region; and (C) thermally treating the GaN-based electronic device on which the electrode layer is formed.

Another embodiment of the present invention provides an ohmic contact of the GaN-based electronic device manufactured by the method for forming an ohmic contact of a GaN-based electronic device.

### [Advantageous Effect]

In the method for forming an ohmic contact of a GaN-based electronic device of the present invention, a metal or metalloid is implanted into a region where an ohmic contact is to be formed in advance, and a nitride is formed from the metal or metalloid that is implanted into the device and the nitrogen derived from the GaN-based material during a thermal treatment process, so that the resistance value of the ohmic contact can be lowered. In particular, since the formation of the nitride is facilitated, an ohmic contact can be formed even at a low temperature unlike in the prior art, and a resistance value required in a high-frequency electronic device can be obtained despite a low-temperature thermal treatment.

Accordingly, it is possible to manufacture an ohmic contact of a GaN-based electronic device optimized to reduce breakdown voltage while preventing an ohmic contact resistance from decreasing. In addition, there are effects of reducing surface damage that greatly affects the GaN-based electronic device, simplifying the process, and having the possibility of developing various electronic device structures.

### [Description of Drawings]

FIG. 1 is a diagram schematically illustrating a method for forming an ohmic contact of a GaN-based electronic device according to an embodiment of the present invention.
FIG. 2 is a diagram illustrating a distribution of Ti ions implanted into the electronic device of Example 1 according to Experimental Example 1 of the present invention.
FIG. 3 is a diagram illustrating a Ti ion implantation amount according to a Ti ion implantation depth of the electronic device of Example 1 according to Experimental Example 1 of the present invention.

### [Mode for Invention]

The present invention may be modified in various forms, and specific embodiments thereof will be described and illustrated in the drawings. However, it is to be understood that the embodiments are not intended to limit the invention but to include all modifications, equivalents and substitutions falling within the spirit and scope of the invention.

The terms used in the specification are used to merely describe specific embodiments, but are not intended to limit the invention. An expression of a singular number includes an expression of the plural number unless the context clearly dictates otherwise.

In the specification, the expression "∼ on" may mean that members are directly joined and attached, or may mean that members are positioned adjacent to each other.

Thus, configurations illustrated in the embodiments described in the specification are merely most preferable embodiments but do not represent all of the technical spirit of the present invention, and thus, there may be various equivalents and modifications that can replace the configurations at the time of filing this application.

Hereinafter, the present invention will be described in detail.

The present invention provides a method for forming an ohmic contact of a GaN-based electronic device.

The method for forming an ohmic contact of a GaN-based electronic device may comprise (A) irradiating an ion beam on a GaN-based electronic device to form an ion region in a part of an inside of the GaN-based electronic device; (B) forming an electrode layer on a portion of a surface of the GaN-based electronic device, corresponding to the ion region; and (C) thermally treating the GaN-based electronic device on which the electrode layer is formed.

The electronic device refers to electronic components using the conduction of electrons in a solid, and may refer to, for example, a diode, a transistor, a power semiconductor device, a high-frequency device, a sensor, a light emitting device(LED), a solar cell, or the like, but is not limited thereto.

The GaN-based electronic device refers to an electronic device including a GaN-based material. For example, the GaN-based electronic device may be an electronic device including a wafer containing a GaN-based material. Specifically, the GaN-based material may include GaN or AlGaN, but is not limited thereto.

The gallium nitride(GaN) is a material having a wide bandgap (WBG) that is strong at high pressure and high temperature than conventional silicon(Si), and when using a GaN-based electronic device, especially an AlGaN/GaN-based heterojunction structure, it has excellent current characteristics and fast signal conversion speed by utilizing a 2 dimensional electron gas (2DEG) layer with high electron concentration and mobility, so that it is suitable for high-frequency and/or high-power electronic devices.

The GaN-based electronic device may be an AlGaN/GaN-based heterojunction electronic device. That is, the GaN-based electronic device may include a wafer having an AlGaN/GaN-based heterojunction.

In addition, the GaN-based electronic device may further include a substrate. That is, the GaN-based electronic device may include a stacked structure in the order of substrate/GaN/AlGaN.

The substrate may include, for example, sapphire(Al₂O₃), silicon (Si), or silicon carbide (SiC).

The GaN-based electronic device may be manufactured using a known thin film deposition growth technique such as molecular beam epitaxy(MBE), metal organic chemical vapor deposition(MOCVD), or hydride vapor phase epitaxy(HVPE), but is not limited thereto. In particular, due to the hexagonal wurtzite crystalline structure and growth direction characteristics of gallium nitride(GaN), the use of metal organic chemical vapor deposition(MOCVD) is advantageous in that a thin film of superior quality can be obtained in depositing a GaN-based material, and deposition may be performed on multiple substrates at the same time, but the present invention is not limited thereto.

The metal organic chemical vapor deposition(MOCVD) as described above is a method of supplying an organometallic compound (organometal raw material gas) into a reactor and thermally decomposing it on a heated substrate to grow a compound crystal. There is an advantage in that the thickness of the heterojunction can be adjusted to a nano level by controlling the flow rate of the highly purified organometallic compound and the temperature and pressure of the reactor.

The ion beam in step (A) may include an ion beam derived from a metal or a metalloid.

The ion beam is in the form of a charged particle beam made of ions, and is also referred to as a particle beam or an electron beam. This ion beam irradiation technique uses a phenomenon in which kinetic energy of ion beam particles (ions) having high energy is transmitted to the surface of an electronic device and converted into kinetic energy. Ions incident on the surface of the electronic device irradiated with the ion beam cause a collision cascade of atoms of the electronic device, and the properties of the material may be modified by elastic or inelastic collision. In this case, if the ion beam energy is higher than the binding energy of surface atoms, a sputtering phenomenon occurs in which ions break atomic bonds on the surface and emit the atoms to the outside. Conversely, if the ion beam energy is lower than the binding energy of surface atoms, ion implantation occurs, in which the surface of the ion collides with the surface atoms in a chain and the ions are remained.

Immediately after the ion implantation, a defect occurs in the crystal structure due to collision, and in order for the implanted ions to function as dopants, the ions must be positioned at substitution sites in the crystal structure, but due to defects, the crystal structure is defective compared to the original crystal structure and is not electrically activated. Therefore, it is necessary to recrystallize the defective crystal structure through an annealing process to restore it to a normal state, and to move the implanted ions to a substitution site in the crystal structure to act as dopants and electrically activate it. The annealing method includes furnace annealing, rapid thermal annealing, laser annealing, e-beam annealing, or the like.

The metal may include at least one selected from the group consisting of titanium(Ti), aluminum(Al), and tantalum(Ta).

The metalloid may include silicon(Si).

The metal or metalloid may form a low resistance through a combination with the nitrogen atom(N) contained in the GaN-based electronic device, and among the metal or metalloid, it is preferable to use an ion beam derived from titanium(Ti) in terms of low resistance.

The ion beam in step (A) may be irradiated with energy of 15 to 20 keV. If the ion implantation energy is less than 15 keV, ions are implanted above the AlGaN/GaN interface, making it difficult to have a low resistance. Also, if the ion implantation energy exceeds 20 keV, ions are implanted deeper than the AlGaN/GaN interface, so that there is a problem that it is difficult to have a low resistance.

In the case that the GaN-based electronic device includes an AlGaN/GaN-based heterojunction electronic device, the AlGaN layer may have a thickness of 100 Å to 400 Å. If the thickness of the AlGaN layer does not satisfy the above range, the characteristics of the 2DEG may deteriorate.

Since the 2DEG is located within 100 Å of the AlGaN/GaN interface in the direction of gravity, the depth for forming the ion region may be adjusted in consideration of the location of the 2DEG. The depth at which the ion region in step (A) is formed may be 100 Å to 500 Å in the direction of gravity (vertical direction to the surface) from the surface of the GaN-based electronic device corresponding to the ion region. If the depth at which the ion region is formed satisfies the above range, a nitride layer between ions and nitrogen derived from the GaN-based electronic device is formed at the AlGaN/GaN interface to have a low contact resistance.

An average ion implantation amount of the ion beam implanted into the GaN-based electronic device in step (A) may be 1 × 10¹⁴ to 1 × 10¹⁶ ions/cm². If the average ion implantation amount of the ion beam satisfies the above range, the ions of the ion beam combine with nitrogen atoms(N) inside the GaN-based electronic device to form nitride, and thus, may have a low ohmic contact resistance.

Before irradiating the ion beam in step (A), the method may include patterning a portion of the GaN-based electronic device to which the ion beam is irradiated.

The patterning may include masking a remaining surface portion of the GaN-based electronic device except for a surface portion into which ions are implanted through the ion beam. That is, the ions derived from the ion beam may be selectively implanted into the GaN-based electronic device through an unmasked portion of the surface of the GaN-based electronic device.

The patterning may be performed by a photolithography method, but is not limited thereto.

In the case that the patterning is performed by a photolithography method, a known photolithography method may be used, and generally may be performed in the order of wafer cleaning/photoresist coating/masking/exposure/development/photoresist removal, but is limited thereto. In the present invention, some of the above-listed processes may be omitted or additional processes may be added depending on process conditions.

That is, as described above, the patterned region formed before step (A) is not removed immediately after step (A), but it may be removed after forming the electrode layer in step (B) but before the thermal treatment in step (C).

For example, in the case that the patterning is performed by a photolithography method, the removing the patterned region may mean removing the coated photoresist.

That is, the electrode layer may be formed only on a portion of the surface of the GaN-based electronic device corresponding to the ion region.

The electrode layer may mean a concept including a source and/or a drain.

The electrode layer may include an electrode material having a work function smaller than that of a GaN-based material.

The electrode layer may be prepared using a known thin film deposition growth technique, for example, electron beam evaporation, thermal evaporation, sputtering, electroless plating, or the like, but may be formed using a thin film growth technique, but is not limited thereto.

The electrode material may include at least one selected from the group consisting of titanium(Ti), aluminum(Al), nickel(Ni), gold(Au), silicon(Si), tantalum(Ta), and alloys thereof.

The electrode layer may be a single layer or a plurality of layers formed by depositing various electrode materials.

Finally, the GaN-based electronic device on which the electrode layer is formed may be thermally treated. In the thermal treatment, a known annealing method for an electronic device may be used.

In this case, the thermal treatment in step (C) may include forming nitride derived from the nitrogen atoms (N) contained in the GaN-based electronic device in the ion region. For example, in the case that titanium(Ti) ions are included in the ion region, the nitride may include titanium nitride(TiN).

Since the nitride affects the mobility of electrons flowing into or out of the ohmic contact, the ohmic contact resistance may be reduced.

The method may include contacting the nitride formed by the thermal treatment in step (C) with the electrode layer.

The method for forming an ohmic contact of a GaN-based electronic device of the present invention can form an ion region even inside the GaN-based electronic device by using an ion beam, compared to the conventional technique of depositing titanium on the surface of the device. Also, it can easily adjust the thickness and/or depth of the ion region, so that the formation of nitride in which ions of the ion beam and nitrogen atoms(N) are bonded is facilitated, thereby reducing the ohmic contact resistance of the GaN-based electronic device.

The thermal treatment in step (C) may be performed at a temperature of less than 800 °C. That is, unlike conventional technologies requiring high-temperature thermal treatment at 800 °C or higher, the method for forming an ohmic contact of a GaN-based electronic device according to the present invention can realize an ohmic contact that simultaneously satisfies the characteristics of contact resistance and breakdown voltage even at a low heat treatment temperature. The thermal treatment in step (C) may be performed at a temperature of 600 °C or more and less than 800 °C.

Before the thermal treatment in step (C), the method may further include the step of removing the patterned region.

For example, in the present invention, after forming the ion region in step (A), a lift-off process may be performed after (B) forming the electrode layer on a portion of the surface of the GaN-based electronic device corresponding to the ion region. In the present invention, the lift-off process may refer to a method of patterning the electrode layer using a material such as photoresist, or, as described above, in the case that the patterning is performed by a photolithography method, the lift-off process may mean removing the photoresist.

Another embodiment of the present invention provides an ohmic contact of a GaN-based electronic device manufactured according to the method for forming an ohmic contact of a GaN-based electronic device described above.

The ohmic contact of the GaN-based electronic device has a low contact resistance despite being manufactured at a low heat treatment temperature, and at the same time, the breakdown voltage is improved, so that a better high-frequency electronic device can be implemented.

Therefore, this high-frequency electronic devices can be applied to various high-frequency applications such as 5G, autonomous vehicles, and military radar modules.

Hereinafter, the present invention will be described in more detail with reference to preferred embodiments.

However, these examples are intended to explain the present invention in more detail, and the scope of the present invention is not limited thereby.

### <Example 1>

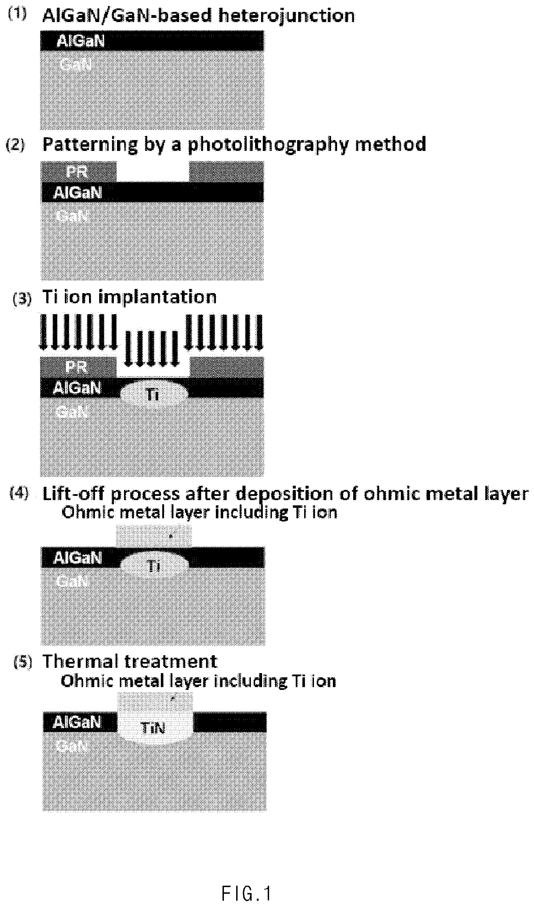

As illustrated in FIG. 1, (1) the AlGaN/GaN heterojunction structure stacked on a substrate (but not illustrated) was used as a wafer, (2) a photolithography method was used to pattern a region where a source/drain was to be formed. Then, (3) a 20 keV titanium(Ti) ion beam was irradiated, (4) a Ti/Al/Ni/Au electrode layer was deposited on the patterned portion by e-beam evaporation, and then, the photoresist was removed by a lift-off process. Then, (5) an ohmic contact was formed by thermal treatment at a temperature of less than 800 °C.

### <Experimental Example 1>

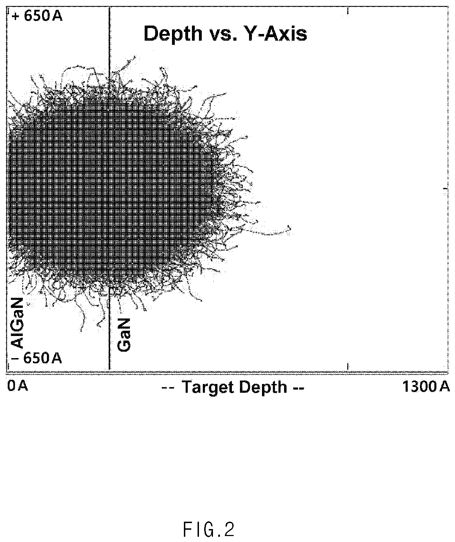

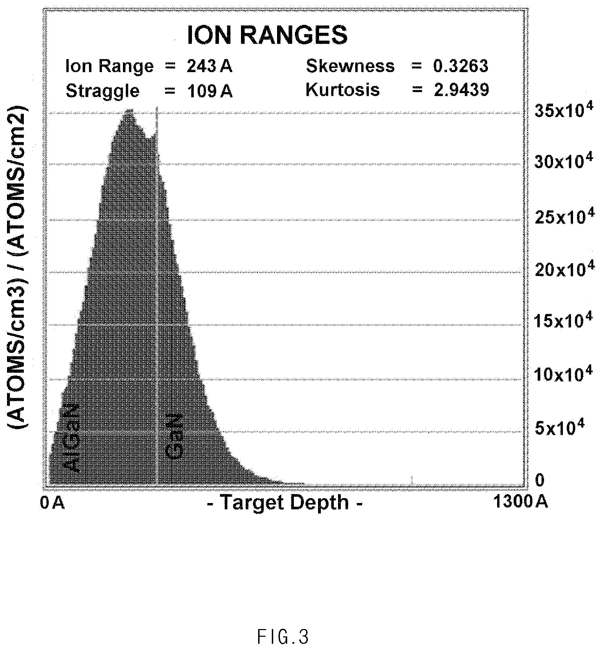

In Example 1, the distribution of implanted titanium(Ti) ions when irradiated with the 20 keV titanium (Ti) ion beam was shown in FIG. 2, and the titanium (Ti) ion implantation amount according to the titanium(Ti) ion implantation depth was shown in FIG. 3.

## Claims

1. A method for forming an ohmic contact of a GaN-based electronic device, comprising:
(A) irradiating an ion beam on a GaN-based electronic device to form an ion region in a part of an inside of the GaN-based electronic device;
(B) forming an electrode layer on a portion of a surface of the GaN-based electronic device, corresponding to the ion region; and
(C) thermally treating the GaN-based electronic device on which the electrode layer is formed.

2. The method of claim 1, wherein the GaN-based electronic device includes an AlGaN/GaN-based heterojunction electronic device.

3. The method of claim 1, wherein the ion beam in the step (A) includes the ion beam derived from a metal or metalloid.

4. The method of claim 3, wherein the metal includes at least one selected from the group consisting of titanium(Ti), aluminum(Al), and tantalum(Ta), and the metalloid includes silicon(Si).

5. The method of claim 1, wherein the ion beam in the step (A) is irradiated with energy of 15 to 20 keV.

6. The method of claim 1, further comprising, before irradiating the ion beam in the step (A), patterning a portion of the GaN-based electronic device to which the ion beam is irradiated.

7. The method of claim 6, wherein the patterning is performed by a photolithography method.

8. The method of claim 1, wherein the electrode layer includes an electrode material having a work function smaller than that of a GaN-based material.

9. The method of claim 8, wherein the electrode material includes at least one selected from the group consisting of titanium(Ti), aluminum(Al), nickel(Ni), gold(Au), silicon(Si), tantalum(Ta), and alloys thereof.

10. The method of claim 1, wherein the thermal treatment in the step (C) includes forming nitride derived from nitrogen atom(N) contained in the GaN-based electronic device in the ion region.

11. The method of claim 10, wherein the nitride formed by the thermal treatment in the step (C) is in contact with the electrode layer.

12. The method of claim 1, wherein the thermal treatment in the step (C) is performed at a temperature of less than 800 ° C.

13. The method of claim 6, further comprising, before the thermal treatment in the step (C), removing the patterned region.

14. An ohmic contact of a GaN-based electronic device manufactured by the method for forming the ohmic contact of the GaN-based electronic device of any one of claims 1 to 13.
